# EUROPÄISCHE PATENTSCHRIFT

(11) **EP 0 909 408 B1**
(45) Veröffentlichungstag und Bekanntmachung des Hinweises auf die Patenterteilung: **18.10.2000**
(21) Anmeldenummer: 97936641.6
(22) Anmeldetag: 15.07.1997
(51) Int. Cl.: G03F 7/12

(54) **VERFAHREN ZUM HERSTELLEN EINER SIEBDRUCKFORM SOWIE SIEBDRUCKGEWEBE AUS EINER BESCHICHTETEN SIEBBAHN**
PROCESS FOR PRODUCING A SCREEN PRINTING FORM AND SCREEN PRINTING FABRIC OF A COATED SCREEN WEB
PROCEDE DE PRODUCTION D'UNE FORME POUR SERIGRAPHIE ET TISSU SERIGRAPHIQUE CONSTITUE D'UNE BANDE CONTINUE ENDUITE

(30) Priorität: 16.07.1996 DE 19628616; 14.11.1996 DE 19646987
(43) Veröffentlichungstag der Anmeldung: 21.04.1999
(73) Patentinhaber: Sefar AG, 9425 Thal (CH)
(72) Erfinder: SCHILLING, Christian, CH-8472 Seuzach (CH)
(74) Vertreter: Hiebsch, Gerhard F., Dipl.-Ing.
(86) Internationale Anmeldenummer: EP9703785
(87) Internationale Veröffentlichungsnummer: WO9802785

(56) Entgegenhaltungen:
- EP-A- 0 428 121
- EP-A- 0 595 776
- FR-A- 821 243
- US-A- 3 834 348
- PATENT ABSTRACTS OF JAPAN vol. 017, no. 658 (P-1654), 6.Dezember 1993 & JP 05 216239 A (TOYO ELECTRIC MFG CO LTD), 27.August 1993, & DATABASE WPI Week 9339 Derwent Publications Ltd., London, GB; AN 93-306054 & JP 05 216 239
- PATENT ABSTRACTS OF JAPAN vol. 7, no. 30 (P-173), 5.Februar 1983 & JP 57 181550 A (TOUKIYOU PROCESS SERVICE K.K.), 9.November 1982,

## Beschreibung

Die Erfindung betrifft ein Verfahren zum Herstellen einer Siebdruckform aus einer Siebbahn, beispielsweise aus Kunststoffilamenten, durch Beschichten mit einer -- insbesondere lichtempfindlichen -- Emulsion. Zudem erfaßt die Erfindung eine Siebdruckform aus einer beschichteten Siebbahn.

Das Siebdruckverfahren ist -- Jahrhunderte nach seiner ersten Anwendung in China -- etwa seit dem 19. Jahrhundert in Europa bekannt; ein feinmaschiges Textil- oder Drahtgewebe wird in einem Siebdruckrahmen aufgespannt und in den bildfreien Bereichen mit einer Schablone farbundurchlässig abgedeckt. Neben manuellen Schnittschablonen -- etwa für Beschriftungen -- sind heute bevorzugt photographisch hergestellte Direkt- oder Indirektschablonen üblich; die Wahl der Schablonenart -- bei den Direktschablonen solche mit Emulsion, mit Direktfilm und Emulsion oder mit Direktfilm und Wasser -- bleibt dem Siebdrucker überlassen.

Um eine Siebdruckform herzustellen, bedarf es üblicherweise mehrerer Schritte. Zuerst wird ein Siebdruckgewebe über einem Druckrahmen aus Leichtmetall, Holz od.dgl. aufgespannt und in seiner Spannlage mit dem Druckrahmen verklebt. Dann wird das Gewebe mit lichtempfindlicher Emulsion -- beispielsweise unter Einsatz einer Beschichtungsrinne manuell oder maschinell mit einem Beschichtungsautomaten -- beschichtet. Da die Beschichtung nicht exakt bis zur Rahmeninnenseite erzeugt werden kann, muß die Restfläche nachträglich mit Siebfüller abgedichtet werden. Nunmehr wird die beschichtete Fläche mittels einer dem Druckbild entsprechenden Kopiervorlage (Film) belichtet. Die nicht belichteten Druckbildbereiche werden ausgewaschen. Nach dem Trocknen der Schablone erfolgt das Retuschieren sowie das Abdecken der Ränder mit Siebfüller.

Es hat sich u. a. als schwierig erwiesen, auf den den üblicherweise in sog. Taffet-Bindung hergestellten Siebgeweben eine exakte ebene Schichtoberfläche zu erzielen. Bedingt durch den niedrigen Festkörperanteil -- üblicherweise unter 50 % -- der Emulsion sinkt die Schicht beim anschließenden Trocknungsprozeß in die Maschenöffnungen des Gewebes ein, womit eine gewisse Rauheit der Oberfläche entstehen kann. Für gewisse Anwendungsgebiete mag diese Oberflächengüte ausreichen, doch für höhere Qualitätsansprüche ist zumindest ein weiterer Beschichtungsvorgang angebracht.

Soll eine Mehrzahl kleiner Rahmen -- beispielsweise zum Herstellen kleinflächiger Druckbilder -- bespannt werden, wird ein sogenannter Mutterrahmen eingesetzt und auf diesem das Siebgewebe aufgespannt; dieses ist am Mutterrahmen beispielsweise durch in der EP 0 650 832 A1 der Anmelderin beschriebene Spannklammern gehalten. Man legt die kleineren Siebdruckrahmen auf eine Unterlage und über diese die unter Spannung gehaltene Siebbahn.

Ein Verfahren zum Herstellen photochemisch beschichteten Materials für Siebdruckzylinder offenbart die DE 34 41 593 A. Dabei wird ein Chromstahldrahtgewebe mit geeigneter Maschenweite mit Nickel elektrolytisch, chemisch oder durch Vakuumbedampfung soweit beschichtet, daß die Kreuzungspunkte des Gewebes verschiebungsfrei befestigt sind; das verfestigte Material wird dann mit zumindest einer Schicht aus einer lichtempfindlichen Emulsion durch Auftragen dieser Emulsion auf einer ebenen Oberfläche und Einbetten des Gewebes in die Rückseite der Emulsionsschicht sowie deren Verbindung durch Auftragen einer weiteren Emulsionsschicht so beschichtet, daß eine ebene Kopierschicht auf der druckseitigen Oberfläche der Siebschablone entsteht.

Die US 3 834 348 A beschreibt einen -- weitenveränderlichen -- Spannrahmen mit einem darin unter Einsatz von Spannelementen festgelegten Gewebefeld. Über diesem ist eine Rinne für ein viskoses Fluid bzw. eine Emulsion verfahrbar, welch letztere aus benachbarten Schlitzen der Rinnenwand auf das Gewebefeld fließt, um auf diesem eine Beschichtung zu bilden. Diese wird anschließend auf dem Gewebefeld getrocknet oder gehärtet.

Die JP 5 216 239 A offenbart einen Behälter mit Spannrahmen, in dem ein Gewebe mit einem photosensitiven Film überzogen wird. Das Fluid wird in den Behälter eingeleitet, bis sich eine gewünschte Schichtdicke auf dem Gewebe eingestellt hat. Dann wird das Fluid partiell belichtet; die unbelichteten Bereiche werden nach Beendigung der Behandlung entfernt, so daß ein Bild entsteht.

In Kenntnis dieser Gegebenheiten hat sich der Erfinder das Ziel gesetzt, ein Verfahren der eingangs beschriebenen Art zu verbessern und vor allem das problemlose Herstellen von begrenzten Beschichtungsfeldern zu ermöglichen, die durch einen Klebevorgang mit einem Spannrahmen verbunden werden sollen.

Zur Lösung dieser Aufgabe führt die Lehre der unabhängigen Patentansprüche; die Unteransprüche geben günstige Ausgestaltungen an.

Erfindungsgemäß wird eine Siebbahn innerhalb einer vorgegebenen Umrißkontur partiell mit aus der Emulsion bestehenden Beschichtungsfeldern versehen, wobei die Emulsion bevorzugt bahnförmig oder auch punktweise auf die Siebbahn aufgebracht wird. Vorteilhaft ist es, für das Auftragen zumindest eine Düse einzusetzen, die parallel zur Längsrichtung der Siebbahn über das Siebgewebe geführt wird und seitlich aneinandergrenzende Beschichtungsstreifen erzeugt, die gemeinsam das Beschichtungsfeld ergeben.

Die Beschichtungsfelder können auf unterschiedliche Weise erzeugt werden. Zum einen können sie -- bei niedrigen Anforderungen, rauher Oberfläche -- direkt auf die Siebbahn aufgetragen und anschließend getrocknet werden. Auch ist es möglich, diese direkt auf die Siebbahn applizierten Beschichtungsfelder mit einer Schutzfolie zu kaschieren und erst dann zur Trocknungsstation zu bringen; dies geschieht vor allem bei hohen Anforderungen und gutem Rauhigkeitswert in der Z-Achse. Besonders vorteilhaft ist es aber, die Beschichtungsfelder auf einem stabilen Trägermaterial zu erzeugen und letzteres mit den nassen Emulsionsbereichen der Siebbahn zuzuführen; dann werden diese Emulsionsbereiche auf die Siebbahn transferiert und anschließend getrocknet. Dann wird jenes Trägermaterial abgezogen oder aber als Schutzfolie vorläufig an der Siebbahn gehalten.

Es liegt im Rahmen der Erfindung, daß eine Mittellinie des entstehenden -- durch seine bevorzugt vier Umrißlinien definierten -- Beschichtungsfeldes mit einer Längskante der Siebbahn einen Neigungswinkel einschließt; die Umrißlinien sind um das Zentrum des Beschichtungsfeldes in jenem Winkel -- von bevorzugt weniger als 45° -- gedreht.

Das Auftragen der Beschichtungsfelder in einem Neigungswinkel zur Siebbahn läßt erfindungsgemäß ein gewinkeltes Aufspannen der beschichteten Gewebeabschnitte auf einem Druckrahmen zu. Gewinkelt aufgespannte Gewebe ermöglichen einen sauberen Druck von Linien, die parallel zum Siebdruckrahmen gedruckt werden müssen. Entscheidend ist, daß dabei keine Parallelität zwischen dem Fadenverlauf des Siebgewebes und der zu druckenden Linie besteht.

Eine Vereinfachung der Fertigung entsteht vor allem dann, wenn das Beschichtungsfeld aus einzelnen, jeweils von einer Düse od.dgl. Werkzeug erzeugten, parallel benachbarten Beschichtungsbahnen zusammengesetzt wird, deren Längsränder ineinander übergehen, so daß keine das Beschichtungsfeld durchziehende Konturstreifen verbleiben.

Nach einem weiteren Merkmal der Erfindung ist jede Schmalkante der streifenartigen Beschichtungsbahn jeweils einer der Umrißlinien des zur Achse des Mutterrahmens gewinkelten Beschichtungsfeldes zugeordnet.

Im Rahmen der Erfindung liegt es, in die Mittellinie der Kontur des Beschichtungsfeldes die Mittellinie eines dem Beschichtungsfeld zugeordneten Spannrahmens zu legen, der in Abstand zu den Umrißlinien angeordnet und dann mit der Siebbahn in deren gespanntem Zustand außerhalb des Beschichtungsfeldes verklebt wird. Nach dem Abdecken der zwischen Spannrahmen und Beschichtungsfeld verbleibenden Siebbahnbereiche durch eine undurchlässige Schicht entsteht auf einfache Weise eine beschichtete Druckschablone insbesondere für kleinere Flächen, wobei die Anzahl der Umrißlinien des polygonen Beschichtungsfeldes unterschiedlich sein kann.

In besonderen Fällen können die Beschichtungsfelder auch auf eine andere Weise erzeugt werden; die Siebbahn wird an einer Oberfläche mit einer durchgehenden Emulsionsschicht versehen, aus der anschließend die Bereiche entfernt werden, welche nicht zu einem vorgegebenen Muster aus den Beschichtungsfeldern gehören.

Besonders vorteilhaft ist es, diese überflüssigen Zonen der Beschichtung unmittelbar nach deren Auftrag -- also in feuchtem Zustand der Emulsion -- abzusaugen.

Weitere Vorteile, Merkmale und Einzelheiten der durch die Ansprüche definierten Erfindung ergeben sich aus der nachfolgenden Beschreibung bevorzugter Ausführungsbeispiele sowie anhand der Zeichnung; diese zeigt in:

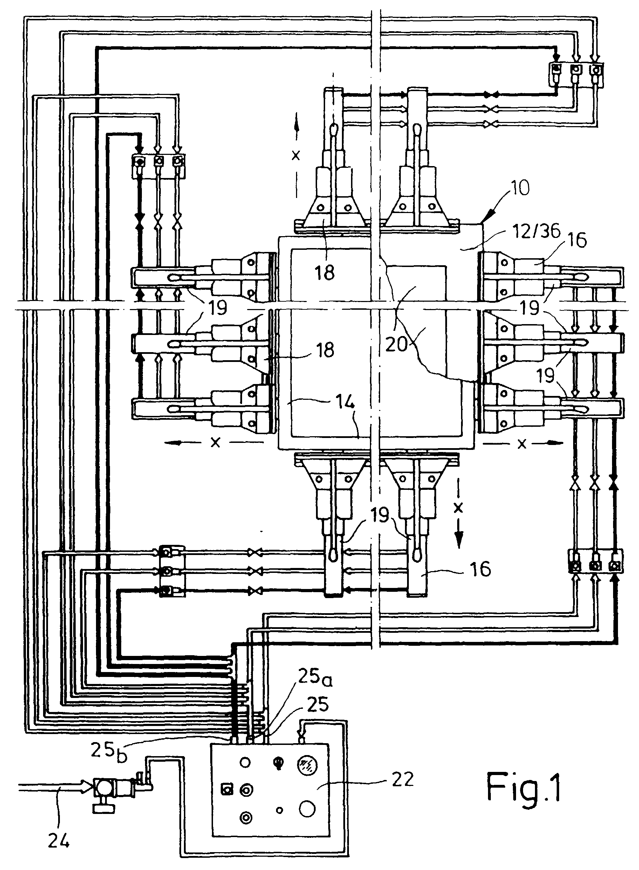

- Fig. 1:: die Draufsicht auf eine Vorrichtung zum Aufspannen eines beschichteten Siebbahnrapports mit Gruppen von Spanneinrichtungen;
- Fig. 2:: eine skizzierte Seitenansicht einer Anlage zum Beschichten einer Siebbahn;
- Fig. 3, 4:: Draufsichten auf eine Siebbahn mit Beschichtungsfeldern;
- Fig. 5, 6:: andere Draufsichten auf die Siebbahn, die gegenüber Fig. 3, 4 verkleinert dargestellt ist;
- Fig. 7:: eine gegenüber Fig. 3 bis 6 vergrößerte Siebbahn mit mehreren beschichteten Bereichen für zugeordnete Spannrahmen;
- Fig. 8:: einen beschichteten Bereich in gegenüber Fig. 7 vergrößerter Draufsicht;
- Fig. 9:: eine der Darstellung der Fig. 2 entsprechende Skizze einer anderen Anlage;
- Fig. 10:: die Draufsicht auf die Anlage der Fig. 9.

Eine Vorrichtung 10 zum Aufspannen eines rechteckigen Zeugstückes bzw. einer Siebbahn 12 aus bevorzugt gazeartigem Siebmaterial zum Einsatz im Siebdruckverfahren weist -- entlang den vier Seiten eines Gestellrahmens 14 -- mehrere Klemmelemente oder Spanneinrichtungen 16 auf. Diese ergreifen mit jeweils einem Klemmaul 18 einen Abschnitt der Siebbahn 12 in deren Randbereich und spannen die dann ringsum festliegende Siebbahn 12 durch Verstellen jeweils eines Zugzylinders 19 in Zugrichtung x. Die Siebbahn 12, deren Oberfläche mit Beschichtungsfeldern 20 versehen ist, liegt dem Mutterrahmen 14 auf und wird von dessen Außenkante zum Klemmaul 18 in dessen Schließstellung in einem nicht wiedergegebenen Winkel von etwa 6° abwärts gezogen.

Bei 22 ist eine aus einer Leitung 24 mit max. 10 bar Druckluft gespeiste Steuereinheit angedeutet, von der drei Steuerleitungen 25,25ₐ,25_{b} für die Spanneinrichtungen 16 ausgehen.

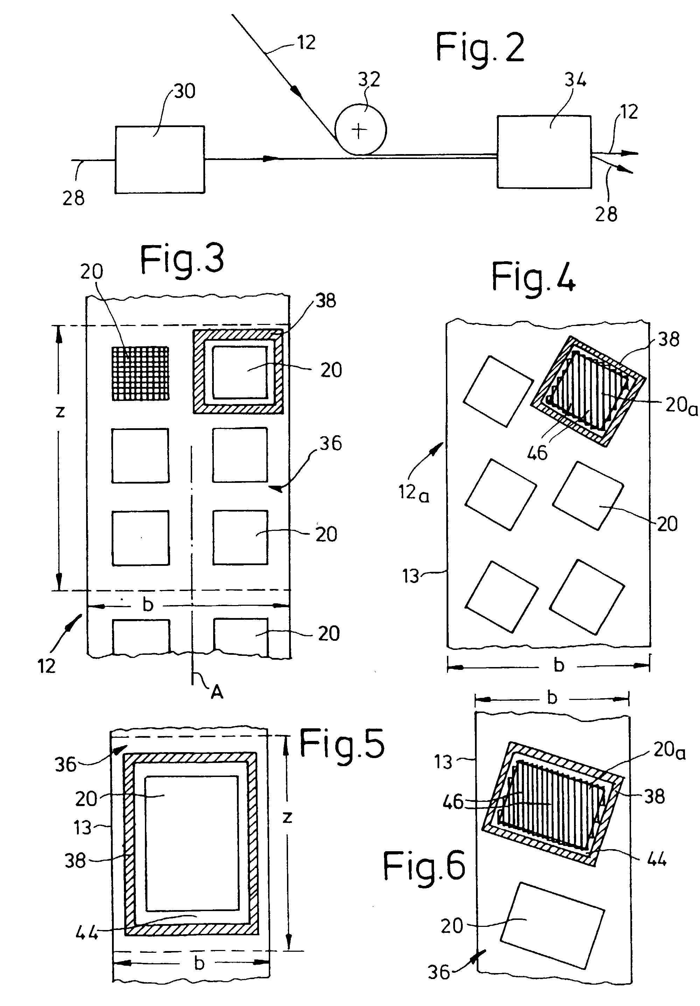

Gemäß Fig. 2 wird der Siebbahn 12 ein bahnartiges Trägermaterial 28 zugeführt, das in einer Beschichtungsstation 30 in einem noch zu beschreibenden Auftragsvorgang mit -- aus Gründen der Übersichtlichkeit in der Zeichnung nicht dargestellten -- Bereichen aus lichtempfindlicher Emulsion beschichtet wird; diese Bereiche entsprechen in ihren Abmessungen und Abständen zueinander beispielsweise den Beschichtungsfeldern 20 auf der Siebbahn 12 der Fig. 3. Das mit jenen Bereichen beschichtete Trägermaterial 28 trifft an einer Kaschierstation 32 auf die Siebbahn 12, wobei unter Druck die Schicht aus lichtempfindlicher Emulsion auf die Siebbahn 12 übertragen und anschließend in einer Durchlaufstation 34 getrocknet wird.

Nach der Durchlaufstation 34 finden sich die Beschichtungsfelder 20 in der zuvor auf dem Trägermaterial 28 vorhandenen Konfiguration auf der Siebbahn 12; diese kann nun vom Trägermaterial 28 getrennt oder mit diesem als zeitweiligem Schutzbelag abgefördert werden.

Nicht dargestellt ist ein Verfahrensschema für -- ohne jenes folienartige Trägermaterial 28 -- unmittelbar auf die Siebbahn 12 aufgetragene Beschichtungsfelder; dabei wird die Siebbahn nach der Beschichtungsstation 30 entweder sofort der Trocknungs- bzw. Durchlaufstation 34 zugefördert oder vor letzterer mit einer Schutzfolie versehen, die nach dem Trocknungsprozeß entfernt werden kann.

In Fig. 3 ist eine Siebbahn 12 der Bahnbreite b mit zu deren Längsachse A parallel angeordneten Beschichtungsfeldern 20 skizziert; sechs von ihnen sind innerhalb eines sog. Rapportes 36 der Länge z vorgesehen. Eines dieser Beschriftungsfelder 20 ist der besseren Übersicht wegen durch eine Gitter-Schraffur hervorgehoben. Um das rechts daneben angeordnete Beschichtungsfeld 20 ist beispielhaft ein Spannrahmen 38 gelegt, mit dem dieser Abschnitt der gespannten Siebbahn 12 dann durch einen Klebevorgang verbunden wird.

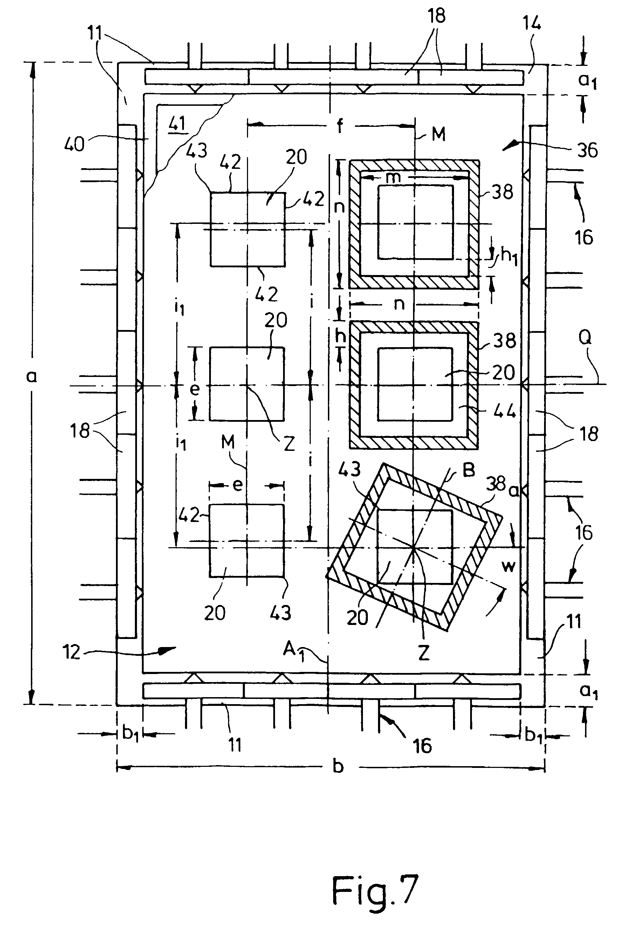

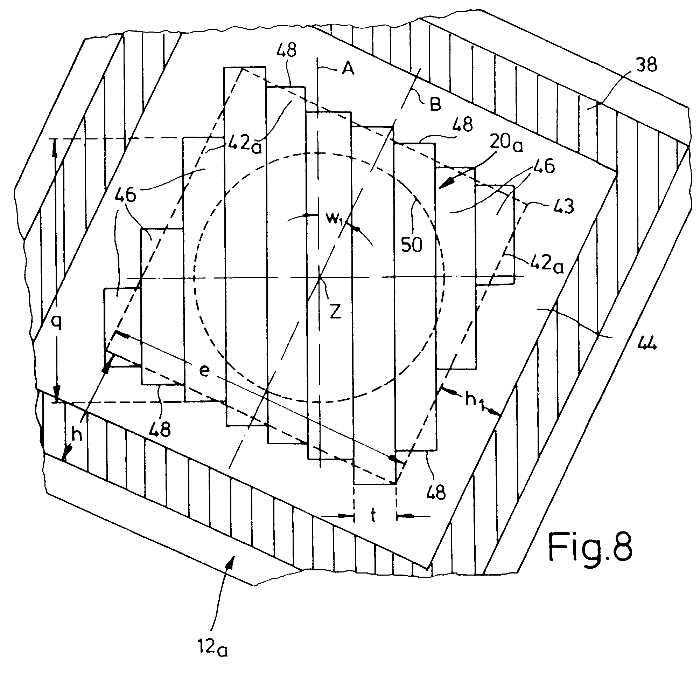

Die Fig. 4 bis 6 verdeutlichen weitere Arten von Beschichtungsfeldern 20, 20ₐ. Die Beschichtungsfelder 20ₐ sind aus einzelnen Bahnen oder Streifen 46 zusammengesetzt, die zu Fig. 7,8 näher beschrieben sind; es handelt sich um bei dem Beschichtungsvorgang auf das offene Gewebe 12ₐ gelegte Beschichtungsstreifen 46, die nach Fertigstellung des Beschichtungsfeldes 20ₐ -- in diesem aufgehend -- nicht mehr zu erkennen sind. Die lichtempfindliche Beschichtung wird mittels einer "Universal"-Düse in Beschichtungsstreifen 46 aufgetragen. Die Beschichtungsfelder 20 werden also bezüglich der jeweiligen Anwendung maßgeschneidert, wie dies auch für Fig. 6 gilt.

In Fig. 4 bis 6 sind außerdem jenen der Fig. 3 entsprechende kleinere Beschichtungsfelder 20ₐ in zur Längsachse A bzw. den parallelen Bahnlängskanten 13 geneigter Lage (Fig. 4) sowie größere Beschichtungsfelder 20, 20ₐ, angedeutet, von denen nur eines oder zwei je Rapport 36 vorhanden ist/sind.

Fig. 7 zeigt einen an einem Gestellrahmen 14 aufgespannten Rapport 36 einer Siebbahn 12 der freien Bahnlänge a von hier etwa 1400 mm und der freien Bahnbreite b von 900 mm mit Klemmelementen 16 zugeordneten Randbereichen 11 der Breite a₁ bzw. b₁. Links oben ist ein Mutterrahmen 40 als Umrandung einer Hilfsplatte 41 aus Holz oder Kunststoff zu erkennen; auf letzterer sind die -- dann vom Rapport 36 überlagerten -- Spannrahmen 38 während des Herstellungsvorganges positioniert.

Auf der freien Fläche des Siebgewebes bzw. der Siebbahn 12 sind -- links von der Längsachse A₁ des Mutterrahmens 40 -- drei der von einer Kontur mit vier Umrißlinien 42 begrenzten quadratischen Beschichtungsfelder 20 aus lichtempfindlicher Emulsion -- bevorzugt der eingangs genannten Art -- als photosensible Beschichtung der Weite e von hier 180 mm dargestellt, die in losem Zustand der Siebbahn 12 in Mittelabständen i von 380 mm -- und i₁ von 394 mm in gespanntem Zustand -- zueinander angeordnet sind. Der Abstand f der zur Längsachse A₁ des Systems parallelen Mittellinie M dieser drei Beschichtungsfelder 20 zur -- ebenfalls parallelen -- Mittellinie M einer zweiten Reihe von -- rechts jener Längsachse A₁ erkennbaren -- Beschichtungsfeldern 20 entspricht sowohl in gespanntem als auch in losem Zustand den Mittelabständen i bzw. i₁. Die mittleren Beschichtungsfelder 20 beider Felderreihen liegen in der Querachse Q des Mutterrahmens 40, zu der jeweils zwei Umrißlinien 42 jedes der quadratischen Beschichtungsfelder 20 parallel liegen.

Jedes der Beschichtungsfelder 20 soll innerhalb der Kontur eines kleinen -- jener Hilfsplatte 41 aufliegenden und der Siebbahn 12 unterlegten -- Spannrahmens 38 so angeordnet sein, daß dieser ohne weiteres mit einer nicht beschichteten Zone des Siebdruckgewebes außerhalb des Beschichtungsfeldes 20 verklebt zu werden vermag; um den Kleber auf das Siebgewebe 12 ohne Beeinflussung des Beschichtungsfeldes 20 aufbringen zu können, soll um letzteres ein beschichtungsfreier Geweberand 44 einer Mindestbreite h -- und in verklebtem Zustand rundum ein freier Rand der Breite h₁ -- verbleiben.

Um den beschriebenen Verbindungsvorgang deutlich werden zu lassen, sind in Fig. 7 beispielhaft Beschichtungsfelder 20 von Druckschablonen für einen direkten Aufdruck auf Compact Discs dargestellt, auf der rechten Seite sind die Beschichtungsfelder 20 innerhalb ihres Spannrahmens 38 skizziert, wobei der untere Rahmen 38ₐ bzw. dessen Rahmenmittelachse B in einem Neigungswinkel w von hier 22,5° um den Mittelpunkt Z des Beschichtungsfeldes 20 aus der Mittellinie M so gedreht ist, daß die Ecken 43 des Beschichtungsfeldes 20 in -- wenn auch geringem -- Abstand zu den Rahmeninnenseiten stehen; die Innenlänge m des Spannrahmens 38,38ₐ beträgt hier 260 mm bei einer Außenlänge n von 310 mm.

Die Mindestbreite h des erwähnten Geweberandes 44 ergibt sich als halbe Differenz zwischen Außenlänge n und Feldesweite e. Deren halbierte Differenz zur Innenlänge m gibt wiederum die freie Randbreite h₁ vor.

Die Beschichtungsfelder 20 sollen mit ihren Konturen innerhalb ihres Spannrahmens 38,38ₐ so angeordnet werden, daß sie rundum zu diesem in Abstand h₁ stehen, was etwa bei geneigten Anordnungen gemäß Rahmen 38ₐ mit Problemen verbunden sein kann. Aus diesem Grunde wird ein u.a. in Fig. 8 dargestelltes Beschichtungsfeld 20ₐ beliebiger Lage der Rahmenmittelachse B mit einem beispielsweisen Neigungswinkel w von 22,5° dadurch erzeugt, daß die es ergebende Emulsion durch nicht gezeigte, parallel zur Bahnlängsachse A geführte Auftragsorgane -- auf das zu Fig. 2 beschriebene Trägermaterial 28 -- in integralen Beschichtungsstreifen 46 geringer Breite t aufgetragen wird. Die unterschiedlichen Längen q der parallel benachbarten Beschichtungsstreifen 46 sind der jeweiligen Lage der gedrehten Umrißlinien 42ₐ angepaßt, und die Schmalkanten 48 jedes Beschichtungsstreifens 46 berühren unterschiedliche Umrißlinien 42ₐ. Innerhalb deren findet sich ein Kreis als Begrenzung 50 des eigentlichen -- nicht wiedergegebenen -- Druckbildes für die Compact Disc.

Nicht dargestellt ist in diesem Zusammenhang eine Ausführung, bei der die Emulsion innerhalb der Umrißlinien 42ₐ etwa punktförmig aufgetragen wird. Ebenfalls ist eine flüssigkeitsundurchlässige Schicht in der Zeichnung vernachlässigt, welche das Beschichtungsfeld 20, 20ₐ umgibt und den beschichtungsfreien Geweberand 44 abdeckt.

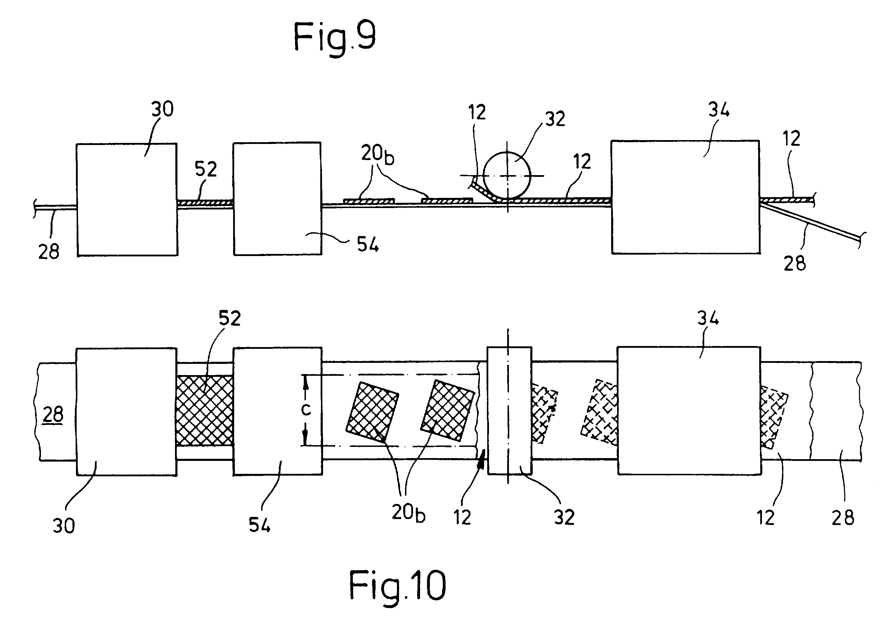

Die Fig. 9, 10 stellen eine gegebenenfalls einzusetzende Alternative zu dem vorstehend beschriebenen Verfahren vor. Hier wird die Trägerfolie 28 in der Beschichtungsstation 30 ganzflächig oder breitstreifig mit einer Schicht 52 der Breite c aus jener Emulsion versehen und sofort anschließend durch eine Absaugstation 54 geführt. In dieser entstehen einzelne Beschichtungsfelder 20_{b} durch Absaugen der bezüglich eines vorwählbaren Musters der Beschichtungsfelder 20_{b} unerwünschten Schichtbereiche.

## Patentansprüche

1. Verfahren zum Herstellen einer Siebdruckform aus einer Siebbahn, beispielsweise aus Kunststoffilamenten, durch Beschichten mit einer Emulsion, insbesondere einer lichtempfindlichen Emulsion, welche getrocknet wird,
dadurch gekennzeichnet,
dass die Siebbahn (12, 12ₐ) partiell mit zumindest einem Beschichtungsfeld (20, 20ₐ) versehen wird, das aus mehreren getrennt aufgetragenen Beschichtungsbereichen zusammengesetzt wird, wobei die Emulsion in zueinander parallel benachbarten Beschichtungsbahnen (46) aufgetragen wird.

2. Verfahren zum Herstellen einer Siebdruckform aus einer Siebbahn, beispielsweise aus Kunststoffilamenten, durch Beschichten mit einer Emulsion, insbesondere einer lichtempfindlichen Emulsion, welche getrocknet wird, dadurch gekennzeichnet, dass die Siebbahn (12, 12ₐ) mit einer Schicht (52) aus der Emulsion versehen wird und mehrere Beschichtungsfelder (20_{b}) durch anschließendes Entfernen von Teilen der Schicht hergestellt werden.

3. Verfahren zum Herstellen einer Siebdruckform aus einer Siebbahn, beispielsweise aus Kunststoffilamenten, durch Beschichten mit einer Emulsion, insbesondere einer lichtempfindlichen Emulsion, welche getrocknet wird, dadurch gekennzeichnet, dass ein bahnartiges Trägermaterial (28) mit einer Schicht (52) aus der Emulsion versehen wird und mehrere Beschichtungsfelder (20_{b}) durch anschließendes Entfernen von Teilen der Schicht hergestellt werden, wonach die Beschichtungsfelder vom Trägermaterial auf die Siebbahn (12) transferiert und letztere getrocknet wird.

4. Verfahren nach Anspruch 2 oder 3, dadurch gekennzeichnet, dass die Schicht (52) aus der feuchten Emulsion durch partielles Absaugen in Beschichtungsfelder (20_{b}) unterteilt wird.

5. Verfahren nach Anspruch 1 oder 2, dadurch gekennzeichnet, dass die Emulsion etwa punktförmig aufgesprüht wird.

6. Verfahren nach einem der Ansprüche 1 bis 5, dadurch gekennzeichnet, dass die Emulsion durch zumindest eine Düse aufgebracht wird, wobei gegebenenfalls die Düse, insbesondere eine Schlitzdüse, parallel zu einer Längskante (13) der Siebbahn (12, 12ₐ) geführt wird.

7. Verfahren nach Anspruch 6, dadurch gekennzeichnet, dass die Beschichtungsfelder (20, 20ₐ, 20_{b}) auf ein bahnartiges Trägermaterial (28) aufgebracht und von diesem auf die Siebbahn (12, 12ₐ) transferiert werden, wonach diese getrocknet wird, wobei gegebenenfalls das bahnartige Trägermaterial (28) von der die Beschichtungsfelder (20, 20ₐ, 20_{b}) tragenden Siebbahn (12, 12ₐ) abgezogen oder das Trägermaterial (28) als Schutzfolie mit der Siebbahn (12, 12ₐ) verbunden wird.

8. Verfahren nach einem der Ansprüche 1 bis 7, dadurch gekennzeichnet, dass die Mittellinie (B) des Beschichtungsfeldes (20ₐ, 20_{b}) in einem Neigungswinkel (w) zur Bahnlängsachse (A) ausgerichtet wird, wobei gegebenenfalls ein Neigungswinkel (w, w₁) von weniger als 50°, bevorzugt unter 30°, gewählt wird.

9. Verfahren nach Anspruch 1, dadurch gekennzeichnet, die Beschichtungsbahnen (46) mit der Mittellinie (B) des Beschichtungsfeldes (20ₐ) bzw. dessen Umrißlinie/n (42ₐ) einen Neigungswinkel (w₁) einschließen, wobei gegebenenfalls ein Neigungswinkel (w, w₁) von weniger als 50°, bevorzugt unter 30°, gewählt wird und/oder jede Schmalkante (48) der streifenartigen Beschichtungsbahn (46) jeweils einer Umrisslinie (42ₐ) des Beschichtungsfeldes (20ₐ) zugeordnet wird.

10. Verfahren nach Anspruch 1 oder 9, dadurch gekennzeichnet, dass die Länge (q) jeder Beschichtungsbahn (46) der durch den Neigungswinkel (w) bestimmten Lage der Umrisslinie (42ₐ) angepasst wird.

11. Verfahren nach wenigstens einem der Ansprüche 1 bis 10, dadurch gekennzeichnet, dass in die Mittellinie (B) der Kontur des Beschichtungsfeldes (20ₐ, 20_{b}) die Mittellinie eines dem Beschichtungsfeld zugeordneten Spannrahmens (38, 38ₐ) gelegt wird, der in Abstand (h₁) zu den Umrisslinien (42ₐ) angeordnet wird, wobei gegebenenfalls der Spannrahmen (38, 38ₐ) mit der Siebbahn (12, 12ₐ) in deren gespanntem Zustand außerhalb des Beschichtungsfeldes (20ₐ, 20_{b}) verklebt und/oder auf die Siebbahn (12, 12ₐ) innerhalb des Spannrahmens (38, 38ₐ) eine das Beschichtungsfeld (20, 20ₐ, 20_{b}) umgebende undurchlässige Schicht aufgetragen wird.

12. Siebdruckform aus einer Siebbahn, beispielsweise aus Kunststoffilamenten, die mit einer Emulsion, bevorzugt einer lichtempfindlichen Emulsion, beschichtet ist, das insbesondere nach wenigstens einem der voraufgehenden Ansprüche 1, 3, 7 bis 11 hergestellt worden ist, dadurch gekennzeichnet, dass die Siebbahn (12) mit aus mehreren Beschichtungsbereichen zusammengesetzten Beschichtungsfeldern (20ₐ) versehen ist, wobei gegebenenfalls die Beschichtungsfelder (20ₐ) auf einem folienartigen Trägermaterial erzeugt und auf die Siebbahn (12) transferiert sind, wobei das Trägermaterial eine Schutzfolie bildet.

13. Siebdruckform nach Anspruch 12, dadurch gekennzeichnet, dass die Beschichtungsfelder (20ₐ) von Beschichtungsbahnen (46) gebildet sind und/oder dass die Beschichtungsbahnen (46) mit der Mittellinie (B) des Beschichtungsfeldes (20ₐ) bzw. dessen Umrisslinie/n (42ₐ) einen Neigungswinkel (w₁) einschließen.

14. Siebdruckform mit zugeordnetem Spannrahmen nach Anspruch 12 oder 13, dadurch gekennzeichnet, dass die Beschichtungsbahnen (46) in einem Neigungswinkel (w₁) zur Rahmenmittelachse (B) eines sie aufnehmenden Spannrahmens (38) verlaufen.

15. Siebdruckform nach Anspruch 12 oder 13, dadurch gekennzeichnet, dass die Siebbahn (12) mit einer das Beschichtungsfeld (20, 20ₐ) umgebenden flüssigkeitsundurchlässigen Schicht eines Geweberandes (44) versehen ist.

16. Siebdruckform nach einem der Ansprüche 12 bis 14, dadurch gekennzeichnet, dass die Beschichtungsbahnen (46) etwa parallel zur Längsachse (A) der Siebbahn (12) verlaufen.

## Claims

1. Process for the production of a screen printing forme from a screen web, e.g. of plastic filaments, by coating with an emulsion, in particular a light-sensitive emulsion, which is dried, characterised in that the screen web (12, 12ₐ) is partially provided with at least one coating panel (20, 20ₐ) composed of a plurality of coating regions applied separately, the emulsion being applied in parallel adjacent coating webs (46).

2. Process for the production of a screen printing forme from a screen web, e.g. of plastic filaments, by coating with an emulsion, in particular a light-sensitive emulsion, which is dried, characterised in that the screen web (12, 12ₐ) is provided with a layer (52) of the emulsion and a plurality of coating panels (20_{b}) are produced by the subsequent removal of parts of the layer.

3. Process for the production of a screen printing forme from a screen web, e.g. of plastic filaments, by coating with an emulsion, in particular a light-sensitive emulsion, which is dried, characterised in that a substrate web (28) is provided with a layer (52) of the emulsion and a plurality of coating panels (20_{b}) are produced by the subsequent removal of parts of the layer, after which the coating panels of the substrate are transferred to the screen web (12) and the latter is dried.

4. Process according to claim 2 or claim 3, characterised in that the layer (52) of damp emulsion (52) is divided into coating panels (20b) by partial suction.

5. Process according to claim 1 or claim 2, characterised in that the emulsion is sprayed on substantially in points.

6. Process according to one of claims 1 to 5, characterised in that the emulsion is applied by means of at least one nozzle, the nozzle, in particular a slot nozzle, possibly being guided parallel to a longitudinal edge (13) of the screen web (12, 12ₐ).

7. Process according to claim 6, characterised in that the coating panels (20, 20ₐ, 20_{b}) are applied to a substrate web (28) and are transferred from there to the screen web (12, 12ₐ), after which the latter is dried, the substrate web (28) then possibly being removed from the screen web (12, 12ₐ) bearing the coating panels (20, 20ₐ, 20_{b}) or the substrate (28) being joined to the screen web (12, 12ₐ) as a protective film.

8. Process according to one of claims 1 to 7, characterised in that the centre line (B) of the coating panel (20ₐ, 20_{b}) is aligned at an angle of inclination (w) relative to the longitudinal axis (A) of the web, an angle of inclination (w, w₁) of less than 50°, preferably less than 30°, possibly being selected.

9. Process according to claim 1, characterised in that the coating webs (46) include an angle of inclination (w₁) with the centre line (B) of the coating panel (20ₐ) or its contour/s, an angle of inclination (w, w₁) of less than 50°, preferably less than 30°, possibly being selected and/or each narrow edge (46) of the coating strip (46) being associated with a respective contour (42ₐ) of the coating panel (20ₐ).

10. Process according to claim 1 or claim 9, characterised in that the length (q) of each coating web (46) is adapted to the position of the contour (42ₐ) determined by the angle of inclination (w).

11. Process according to at least one of claims 1 to 10, characterised in that the centre line of a stretching frame (38, 38ₐ) associated with the coating panel and arranged a distance (h₁) from the contours (42ₐ) is disposed along the centre line (B) of the contour of the coating panel (20ₐ, 20_{b}), the stretching frame (38, 38ₐ) possibly being glued on to the screen web (12, 12ₐ) in its taut state outside the coating panel (20ₐ, 20_{b}) and/or an impermeable layer surrounding the coating panel (20, 20ₐ, 20_{b}) being applied to the screen web (12, 12ₐ) within the stretching frame (38, 38ₐ).

12. Screen printing forme of a screen web, e.g. of plastic filaments, coated with an emulsion, preferably a light-sensitive emulsion, produced, in particular, according to at least one of the preceding claims 1, 3, 7 to 11, characterised in that the screen web (12) is provided with coating panels (20ₐ) composed of a plurality of coating regions, the coating panels (20ₐ) possibly being produced on a substrate film and transferred to the screen web (12), the substrate forming a protective film.

13. Screen printing forme according to claim 12, characterised in that the coating panels (20ₐ) are formed by coating webs (46) and/or that the coating webs (46) include an angle of inclination (w₁) with the centre line (B) of the coating panel (20ₐ) or its contour/s (42ₐ).

14. Screen printing forme with an associated stretching frame according to claim 12 or claim 13, characterised in that the coating webs (46) extend at an angle of inclination (w₁) relative to the centre axis (B) of a stretching frame (38) receiving them.

15. Screen printing forme according to claim 12 or claim 13, characterised in that the screen web (12) is provided with a liquid-impermeable layer of a fabric edge (44) surrounding the coating panel (20, 20ₐ).

16. Screen printing forme according to one of claims 12 to 14, characterised in that the coating webs (46) extend approximately parallel to the longitudinal axis (A) of the screen web (12).

## Revendications

1. Procédé de fabrication d'une forme ou d'un moule pour l'impression sérigraphique, constitué par une bande continue enduite ou bande sérigraphique, par exemple en filaments de matière plastique, par enduction, par une émulsion, en particulier une émulsion photosensible, qui est séchée, caractérisé en ce que la bande sérigraphique (12, 12a) est munie partiellement d'au moins un domaine d'enduction (20, 20a), qui est constitué par assemblage de plusieurs zones d'enduction appliquées séparément, l'émulsion étant appliquée sur des bandes d'enduction voisines (46) parallèles les unes aux autres.

2. Procédé de fabrication d'une forme pour l'impression sérigraphique, constituée par une bande sérigraphique, par exemple en filaments de matière plastique, par enduction par émulsion, en particulier une émulsion photosensible, qui est séchée, caractérisé en ce que la bande sérigraphique (12, 12a) est munie d'une couche (52) de l'émulsion et en ce que l'on prépare plusieurs domaines d'enduction (20b) par élimination subséquente de parties de la couche.

3. Procédé de fabrication d'une forme pour l'impression sérigraphique, constituée par une bande sérigraphique. par exemple en filaments de matière plastique, par enduction par une émulsion, en particulier une émulsion photosensible, qui est séchée, caractérisé en ce qu'un matériau support (28) du genre bande est muni d'une couche (52) de l'émulsion et en ce que plusieurs domaines d'enduction (20b) sont préparés par élimination subséquente de parties de la couche, de telle sorte que les domaines d'enduction du matériau support soient transférés sur la bande sérigraphique (12) et finalement séchés.

4. Procédé selon la revendication 2 ou 3, caractérisé en ce que la couche (52) de l'émulsion humide est subdivisée par aspiration partielle dans les domaines d'enduction (20b).

5. Procédé selon la revendication 1 ou 2, caractérisé en ce que l'émulsion est dispersée par aspersion de façon sensiblement ponctuelle.

6. Procédé selon l'une des revendications 1 à 5, caractérisé en ce que l'émulsion est appliquée par au moins une buse, en particulier une buse à fente, la buse étant, le cas échéant, guidée parallèlement à un bord longitudinal (13) de la bande sérigraphique (12, 12a).

7. Procédé selon la revendication 6, caractérisé en ce que les domaines d'enduction (20, 20a, 20b) sont appliqués sur un matériau support (28) du genre d'une bande, et sont transférés de ce matériau support sur la bande sérigraphique (12, 12a), celle-ci étant ensuite séchée, tandis que le cas échéant, soit le matériau support (28) du genre bande est retiré de la bande sérigraphique (12, 12a) portant les domaines d'enduction (20, 20a, 20b) soit le matériau support (28) est relié à la bande sérigraphique (12, 12a) pour servir de feuille de protection.

8. Procédé selon l'une des revendications 1 à 7, caractérisé en ce que la ligne médiane (B) du domaine d'enduction (20a, 20b) est orientée en présentant un angle d'inclinaison (w) par rapport à l'axe de bande (A), un angle d'inclinaison (w, wl) inférieur à 50°, de préférence inférieur à 30°, étant choisi le cas échéant.

9. Procédé selon la revendication 1, caractérisé en ce que les bandes d'enduction (46) forment avec ligne la ligne médiane (B) du domaine d'enduction (20a), ou avec sa ou ses ligne(s) de contour (42ₐ) un angle d'inclinaison (w1), alors que le cas échéant, un angle d'inclinaison (w, w1) inférieur à 50°, de préférence inférieur à 30° est choisi et/ou que chaque bord étroit (48) de la bande d'enduction (46) du genre bande est associé chaque fois à une ligne de contour (42a) du domaine d'enduction (20a).

10. Procédé selon la revendication 1 ou 9, caractérisé en ce que la longueur (q) de chaque bande d'enduction (46) est adaptée à la position de la ligne de contour (42a) déterminée par l'angle d'inclinaison (w).

11. Procédé selon au moins l'une des revendications 1 à 10, caractérisé en ce que sur la ligne médiane (B) du contour du domaine d'enduction (20a, 20b), est appliquée la ligne médiane d'un cadre de serrage (38, 38a) associé au domaine d'enduction et qui est disposé à distance (h1) des lignes de contour (42a), en ce que, le cas échéant, le cadre de serrage (38, 38a) avec la bande sérigraphique (12, 12a) à son état serré, est collée à l'extérieur du domaine d'enduction (20a, 20b) et/ou en ce que, sur la bande sérigraphique (12, 12a) à l'intérieur du cadre de serrage (38, 38a), est appliquée une couche non perméable entourant le domaine d'enduction (20, 20a, 20b).

12. Forme ou moule sérigraphique constitué d'une bande sérigraphique, par exemple de filaments en matière plastique, qui est enduite avec une émulsion, de préférence du émulsion photosensible, et qui est fabriquée en particulier selon au moins l'une des revendications précédentes (1, 3, 7 à 11), caractérisé en ce que la bande sérigraphique (12) est munie de domaines d'enduction (20a) constitués de plusieurs zones d'enduction assemblées, les domaines d'enduction (20a) étant réalisés, le cas échéant, sur un matériau support du genre feuille et étant transférés sur la bande sérigraphique (12), tandis que le matériau support forme une feuille de protection.

13. Forme ou moule sérigraphique selon la revendication 12. caractérisé en ce que les domaines d'enduction (20a) sont constitués de bandes d'enduction (46) et/ou en ce que les bandes d'enduction (46) présentent, avec la ligne médiane (B) du domaine d'enduction (20a) ou avec son ou ses ligne(s) de contour (42a), un angle d'inclinaison (w1).

14. Forme ou moule sérigraphique avec des cadres de serrage associés selon la revendication 12 ou 13, caractérisée en ce que les bandes d'enduction (46) présentent un angle d'inclinaison (w1) par rapport à l'axe médian de cadre (B) d'un cadre de serrage (38) les recevant.

15. Forme ou moule sérigraphique selon la revendication 12 ou 13, caractérisé en ce que la bande sérigraphique (12) est munie d'une couche imperméable aux liquides et entourant le domaine d'enduction (20, 20a), cette couche imperméable appartenant à un bord textile.

16. Forme ou moule sérigraphique selon l'une des revendications 12 à 14, caractérisée en ce que les bandes d'enduction (46) courent de façon sensiblement parallèle à l'axe longitudinal (A) de la bande sérigraphique (12).
